# EUROPEAN PATENT APPLICATION

(11) **EP 2 273 256 A1**
(43) Date of publication of application: **12.01.2011**
(21) Application number: 09742650.6
(22) Date of filing: 25.03.2009
(51) Int. Cl.: G01N 21/66, H01L 31/042

(54) **SOLAR CELL EXAMINATION APPARATUS AND TRANSFER DEVICE FOR EXAMINATION DEVICES**

(30) Priority: 17.04.2008 JP 2008002452; 30.04.2008 JP 2008002776
(71) Applicant: Nisshinbo Holdings, Inc., Chuo-ku Tokyo 103-8650 (JP)
(72) Inventor: SHIMOTOMAI, Mitsuhiro, Okazaki-shi Aichi 444-8560 (JP); BABA, Fuminobu, Okazaki-shi Aichi 444-8560 (JP)
(74) Representative: Skuhra, Udo
(86) International application number: PCT/JP2009/056774
(87) International publication number: WO 2009/136525

(57) **Abstract**

The present invention provides an inspection apparatus for photovoltaic devices which passes electric current through the photovoltaic devices in a forward direction thereof to make the photovoltaic devices emit electroluminescence light and which is simple-structured and inexpensive. Also, the present invention provides a transport apparatus, which transports stacked constituent members of the photovoltaic devices in pre-laminated state to the inspection apparatus without positional deviation among the constituent members of the photovoltaic devices.

The inspection apparatus for photovoltaic devices includes: a darkroom 110 having an opening (or a transparent plate) 112 in an upper surface thereof; supporting means provided at the upper surface 111 of the darkroom for disposing an inspection-object; a camera 120 provided inside the darkroom 110; and a shading cover that prevents light from entering the darkroom from the opening and from a gap in a boundary between the opening 112 and the photovoltaic devices disposed on the supporting means. The inspection apparatus has a transport apparatus for transporting stacked constituent members of a photovoltaic device in a pre-laminated state to the inspection apparatus. The transport apparatus has endlessly connected transport members with wall portions lower than a thickness dimension of a transparent substrate that is a constituent member of the photovoltaic devices to be transported. The constituent members of the photovoltaic devices are transported and guided by the transport members provided in a pair (in two rows) symmetrically relative to the direction of transportation, so as to prevent positional deviation among the constituent members during transport.

## Description

### Field of the Invention

The present invention relates to an inspection apparatus which is employed to inspect general performance of photovoltaic devices, such as a photovoltaic cell, a photovoltaic string which is formed by connecting photovoltaic cells in series, a photovoltaic device panel which is formed by disposing a plurality of photovoltaic strings in parallel, and the like. Also, the present invention relates to a transport apparatus which is employed for the inspection apparatus.

### Description of the Related Art

It is well known that silicon photovoltaic devices are employed to harness solar energy. In the manufacture of the photovoltaic devices, it is important to evaluate whether the photovoltaic devices have predetermined power generation capacity. The evaluation is usually performed by measuring the output characteristics thereof.

The output characteristics are photovoltaic conversion characteristics evaluated by measuring the current-voltage characteristics of the photovoltaic devices under light irradiation. As a light source, it is desirable to use solar light. However, since the intensity of the solar light varies with weather, a solar simulator is employed. In the solar simulator, a xenon lamp, a metal halide lamp or the like is employed as an alternative to the solar light. If the aforementioned light source has been lit for a long time, the temperature thereof rises, leading to a variation on the light intensity thereof. Based on data collected using flash light of such a lamp, the output characteristic curves of the photovoltaic devices can be plotted by designating voltage as the horizontal axis and current as the vertical axis (for an instance, refer to Patent Document 1).

Another method different from the above-described method using a solar simulator is disclosed in Patent Document 2. In this method, a voltage is applied to a polycrystalline silicon photovoltaic cell in a forward direction so as to emit electroluminescence light (hereinafter referred to simply as "EL light"). By inspection the EL light emitted from the photovoltaic cell, the current density distribution of the photovoltaic cell can be obtained, and the defects of the photovoltaic devices elements can be determined based on the unevenness of the current density distribution. That is, the part which emits no EL light in the photovoltaic cell are determined as defective parts, and if the area of the defective parts is smaller than a predetermined amount, the photovoltaic cell is determined to have a predetermined power generation capacity.

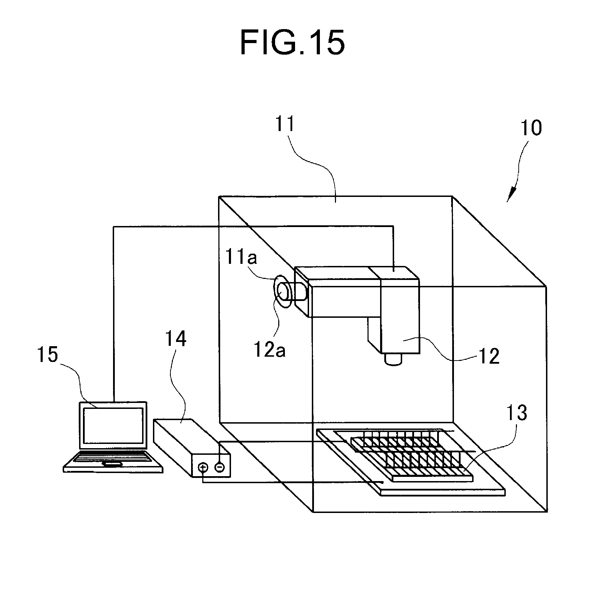

Fig. 15 schematically illustrates the structure of the inspection apparatus disclosed in the Patent Document 2. An inspection apparatus 10 includes a darkroom 11, a CCD camera 12 which is disposed at an upper portion of the darkroom 11, a power source 14 which applies current to a photovoltaic cell disposed on the floor of the darkroom 11, and an image processing apparatus 15 which processes image signals from the CCD camera 12.

The darkroom 11 is provided with a window 11a where a finder 12a of the CCD camera 12 is disposed, and thus an image photographed by the CCD camera 12 can be confirmed by viewing through the finder 12a. A computer is employed as the image processing apparatus 15.
Patent Document 1: JP-2007-088419A
Patent Document 2: WO/2006/059615

### DISCLOSURE OF THE INVENTION

### Problem to be solved by the Invention

In the inspection apparatus 10 illustrated in Fig. 15, the photovoltaic device cell 13 is disposed at a lower side of the darkroom 11 and is photographed by the camera from an upper side thereof. However, EL light is not detected unless the photovoltaic cell is disposed inside the darkroom 11, since the EL light emitted from the photovoltaic cell 13 is a weak light ray of wavelength between 1,000 nm and 1,300 nm. In the case where an inspection-object is a piece of photovoltaic cell, the size thereof is about 100 mm × 100 mm, which is possible to be disposed in a small-sized darkroom.

However, in the case where the inspection-object is a photovoltaic device, the size thereof is about 2 m × 1 m. Therefore, the darkroom 11 needs to have a dimension capable of accommodating inspection-object. In addition, the photovoltaic device as the inspection-object has to be disposed inside the darkroom so as to be photographed by the CCD camera 12. Therefore, the darkroom should be provided with a door through which the photovoltaic devices can be transported into the darkroom or carried out from the darkroom. If the inspection apparatus is configured for the photovoltaic devices to be transported into the darkroom, the shading effect has to be secured when the door is closed. It is also necessary that the inspection apparatus is provided with a positioning member and a guide member for transporting the photovoltaic devices inside the darkroom. Furthermore, it is also necessary that the inspection apparatus is provided with an electrifying means for applying a current to the photovoltaic devices in the darkroom. Thereby, the inspection apparatus becomes complicated in structure and expensive in price.

In addition, the following problems are caused when such an inspection apparatus is incorporated as a part of a production line to manufacture photovoltaic devices. It is needed to set up a long distance between the photovoltaic devices and the camera due to the large-scale of the photovoltaic devices, in case where the entire photovoltaic device is inspected by photographing with the camera and the camera is disposed below the photovoltaic devices. Therefore, it is need to dig out the ground of the factory, which corresponds to the place that the inspection apparatus is disposed, if it is intended to unify a pass-line of the photovoltaic devices in the production line, which is defined as a distance from the ground of the factory to a position that the photovoltaic device panel is transported. Accordingly, an extra expense to adopt the inspection apparatus becomes higher.

Moreover, the following demands exist in case of incorporating such an inspection apparatus as a constituent unit of a production line for photovoltaic devices. It is desired that the stacks of transparent substrates, photovoltaic cells (in the following description, the term "photovoltaic cell" encompasses strings formed by connecting photovoltaic cells in series, as well as panels formed by connecting the plural columns of strings), filling members, and back side members, which constitute photovoltaic devices to be inspection-objects, are transported to the inspection apparatus and inspected there in a pre-laminated state. The photovoltaic devices have become increasingly large to such a degree that the sizes thereof are 2 m × 1 m or more. As described later, in a pre-laminated inspection-object, the back side member at the uppermost surface covers the transparent substrate at the lowermost surface, photovoltaic cells, and filling members. Also, the back side member is stacked in such a manner that the back side member sticks out of the transparent substrate. Thus, if the back side member touches a constituent member of the inspection apparatus during transportation to the inspection apparatus, a positional deviation occurs among the stacked constituent members of the photovoltaic devices. Such a problem during transportation causes positional deviation among strings and cells constituting a photovoltaic device panel, and impedes accurate defect inspection of the photovoltaic cells, resulting in hindrance of the lamination process at a post-process.

An objective of the present invention is to provide a cheap and simply-structured inspection apparatus of photovoltaic devices, which is configured to emit EL light by applying a current to the photovoltaic devices in a forward direction. A second object of the present invention is to provide a transport apparatus for transporting stacked constituent members of the photovoltaic devices to the inspection apparatus in a pre-laminated state without the positional deviation among the constituent members of the photovoltaic devices during transporting.

### Means for Solving the Problem

In order to achieve the foregoing objects, an inspection apparatus for a photovoltaic devices according to the present invention includes: a darkroom having an opening in an upper surface thereof; supporting means provided on the upper surface of the darkroom and on which a photovoltaic devices as an inspection-object is disposed thereon; a camera provided inside the darkroom; and a shading cover that prevents light from entering the darkroom from the opening and from a gap in a boundary between the opening and the photovoltaic devices disposed on the supporting means.

Further, in order to achieve the foregoing objects, an inspection apparatus for a photovoltaic devices according to the present invention includes: a darkroom having a flat upper surface; a transparent plate provided on the upper surface of the darkroom and on which a photovoltaic devices as an inspection-object is disposed thereon; a camera provided inside the darkroom; and a shading cover that prevents light from entering the darkroom from the transparent plate and from a gap in a boundary between the transparent plate and the photovoltaic devices placed on the transparent plate.

The shading cover of the inspection apparatus for the photovoltaic devices may be so configured as to include openable/closable doors in side surfaces thereof for transporting the photovoltaic devices as an inspection-object into and carrying out the photovoltaic devices therefrom. The shading cover may also be so configured as to include an openable/closable door in an upper surface thereof.

The inspection apparatus for the photovoltaic devices may be so configured as to include a mechanism for moving the photographing camera. The inspection apparatus for the photovoltaic devices may also be so configured as to include a reflector plate disposed inside the darkroom obliquely to the upper surface of the darkroom.

In order to achieve the foregoing objects, in a photovoltaic devices inspection apparatus including a darkroom having a flat upper surface, a transparent plate provided at the upper surface of the darkroom and on which a photovoltaic devices as an inspection-object is disposed thereon, and a camera for photographing an image of the inspection-object, the transport apparatus for the inspection apparatus according to the present invention transports stacked constituent members of a photovoltaic devices to the inspection apparatus for the photovoltaic devices in a pre-laminated state. The transport apparatus for the inspection apparatus includes a pair (two rows) of transport guide portions provided symmetrically relative to a direction of transportation. The pair of transport guide portions includes a plurality of endlessly connected transport members having wall portions lower than a thickness dimension of a transparent substrate that is a constituent member of a photovoltaic device to be transported. The transparent substrate is guided with the wall portion and transported.

The transport apparatus for the inspection apparatus may also be configured as follows. A pair (two rows) of transport guide portions is provided symmetrically relative to a direction of transportation. The each transport guide portions include an endless belt-like member having a wall portion lower than a thickness dimension of a transparent substrate that is a constituent member of a photovoltaic device to be transported. The transparent substrate is guided with the wall portions and when transported.

Further, the transport apparatus for the inspection apparatus may be configured such that the wall portions of the transport members or the belt-like members of the transport guide portions of the transport apparatus are positionally variable according to a width dimension of the transparent substrate that is a constituent member of a photovoltaic device to be transported.

### Effect of the Invention

According to the inspection apparatus for photovoltaic devices of the present invention, in case of disposing a photovoltaic devices as an inspection-object onto the transparent plate at the upper surface of the darkroom from the outside of the darkroom, the shading cover prevents light from entering the darkroom from a gap in the boundary between the upper surface of the darkroom and the photovoltaic devices as the inspection-object, and the camera disposed in the darkroom can thus photograph the inspection-object. Since a current is applied to the photovoltaic devices during photographing, the photovoltaic devices emit EL light. Photographing the state of emitting EL light of the photovoltaic devices and analyzing the image photographed by the camera through the image processing apparatus which is connected to the camera enable determining whether the photovoltaic devices is defective or not.

Since an openable/closable door is provided on the upper surface of the shading cover of the inspection apparatus for photovoltaic devices according to the present invention, connectors are easily connected to electrodes of a photovoltaic device for applying current in a forward direction to the photovoltaic cells. Moreover, since openable/closable doors are provided in side surfaces of the shading cover of the present inspection apparatus for the photovoltaic devices, a photovoltaic device, i.e., an inspection-object, is easily transported into the apparatus and carried out therefrom.

In case of installing the inspection apparatus for the photovoltaic devices according to the present invention in a production line for photovoltaic devices, the shading cover of the inspection apparatus for the photovoltaic devices facilitates automation of operations of transporting inspection-objects into, of carrying them out of the apparatus, and of connecting connectors to the electrodes of photovoltaic devices.

It is possible to inspect the photovoltaic devices by disposing it on the upper surface of the darkroom from the outside of the darkroom. Therefore, it is not necessary to provide a door for the photovoltaic devices as the inspection-object to be transported into the darkroom or carried out from the darkroom. Accordingly, it is possible to simplify the structure of the darkroom, thereby, enabling miniaturization thereof.

In particular, it is possible to dispose the camera on a side surface of the darkroom, since the reflector is obliquely disposed with respect to the transparent panel. Therefore, the height of the darkroom can be lowered, even if the photovoltaic device panel as an inspection-object becomes larger. Accordingly, the pass-line of the production line can be unified with the pre-process or the post-process of the inspection apparatus of the present invention.

Further, in the case where the inspection-object is the photovoltaic devices, the photovoltaic devices is transported in a production line (manufacturing apparatus, such as a laminating apparatus) in a state that a light receiving surface is directed downward. Therefore, it is possible to dispose the photovoltaic devices on the inspection apparatus without inversing it, since the inspection apparatus of the present invention is provided with a transparent plate on an upper surface of the darkroom.

According to the transport apparatus for the inspection apparatus according to the present invention, constituent members of photovoltaic devices in a pre-laminated stacked state do not touch other members of the transport apparatus for the inspection apparatus. The positional deviation among the constituent members dose not occur while being transported to the inspection apparatus for the photovoltaic devices.

Thus, defects in the photovoltaic cells are inspected without problems even before the laminating process, and besides the lamination process at a post-process is performed without any disturbance.

Other features and advantages of the present invention will be apparent from the following description when taken in conjunction with the accompanying drawings, in which like reference characters designate similar or identical parts throughout the several views thereof.

### BRIEF DESCRIPTION OF THE DRAWINGS

Fig. 1 is a planar view illustrating an inspection apparatus for photovoltaic devices according to the present invention.
Fig. 2 is a front view illustrating the inspection apparatus for photovoltaic devices according to the present invention.
Fig. 3 is a left side view illustrating the inspection apparatus for photovoltaic devices according to the present invention.
Fig. 4A and Fig. 4B illustrate a shading cover of the inspection apparatus for photovoltaic devices according to the present invention, where Fig. 4A is a planar view and Fig. 4B is a front view.
Fig. 5A and Fig. 5B illustrate the shading cover of the inspection apparatus for photovoltaic devices according to the present invention, where Fig. 5A is a side view as seen in a direction in which an inspection-object is transported in (A direction), and Fig. 5B is a side view as seen in a direction in which the inspection-object is carried out (B direction).
Fig. 6 is a planar view of the shading cover of the inspection apparatus for the photovoltaic devices according to the present invention, illustrating a state in which an openable/closable door on an upper surface thereof is opened.
Fig. 7A and Fig. 7B illustrate the structure of a photovoltaic device to be measured with the inspection apparatus according to the present invention, where Fig. 7A is a planar view showing the structure in such a manner that the interior of the photovoltaic devices is clearly seen, and Fig. 7B is a sectional view thereof.
Fig. 8 is a planar view illustrating the inspection apparatus for the photovoltaic devices provided with a reflector plate inside a darkroom according to the present invention.
Fig. 9 is a left side view illustrating the inspection apparatus for the photovoltaic devices provided with the reflector plate inside the darkroom according to the present invention.
Fig. 10A, Fig. 10B, and Fig. 10C illustrate a camera moving mechanism used in the inspection apparatus according to the present invention, where Fig. 10A is a planar view, Fig. 10B is a front view, and Fig. 10C is a right side view.
Fig. 11 illustrates the first embodiment of a transport apparatus according to the present invention as seen in a direction of transportation of the transport apparatus.
Fig. 12 illustrates the first embodiment of the transport apparatus according to the present invention as seen in a direction perpendicular to the direction of transportation of the transport apparatus.
Fig. 13 illustrates the second embodiment of the transport apparatus according to the present invention as seen in a direction of transportation of the transport apparatus.
Fig. 14A and Fig. 14B illustrate the structure of a photovoltaic devices to be measured with the inspection apparatus according to the present invention, where Fig. 14A is a planar view showing the structure in such a manner that photovoltaic cells inside the photovoltaic devices are clearly seen, and Fig. 14B is a sectional view as seen in a direction in which the inspection-object is transported.
Fig. 15 is a view schematically illustrating a configuration of the conventional inspection apparatus for photovoltaic devices.

### LIST OF REFERENCE SIGNS

- 28: photovoltaic cell
- 30: photovoltaic device panel
- 100: inspection apparatus for photovoltaic devices
- 110: darkroom
- 111: top surface
- 112: opening (transparent plate)
- 114: guide member (transport guide portion)
- 120: camera
- 121: camera mounting portion
- 130: y-axis guide portion
- 132, 142: motor
- 140: x-axis guide portion
- 144: timing belt
- 190: reflector plate
- 191: reflector plate support member
- 200: inspection-object
- 210: transporting-in conveyor
- 220: conveyor apparatus (transport apparatus)
- 221R/L: transport guide member
- 221, 321: transporter
- 222: chain
- 223: upper chain guide
- 224: lower chain guide
- 225: transport guide
- 226: attachment
- 227, 327: wall portion
- 228, 328: thickness portion
- 229, 329: supporting portion
- 322: belt-like member
- 323: upper belt support
- 324: lower belt support
- 230: carrying-out conveyor
- 240: shading cover
- 240: door
- 242: door
- 243: lid
- 244: connector
- 400: controlling device

### PREFERRED EMBODIMENTS OF THE INVENTION

Hereinafter, embodiments according to the present invention are described with reference to the accompanying drawings.

### < 1 > Inspection-object (Photovoltaic device)

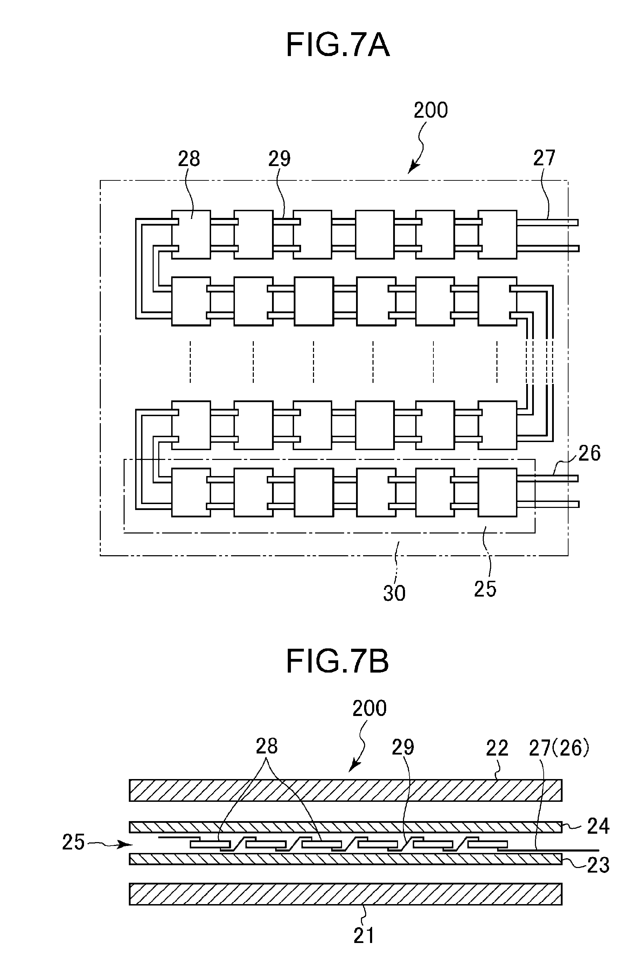

First, the description will be given of an example of an inspection-object 200 which is inspected by an inspection apparatus of an embodiment according to the present invention. Fig. 7A and Fig. 7B illustrate a photovoltaic device inspected by the inspection apparatus of the present invention. Fig. 7A is a planar view showing photovoltaic cells inside the photovoltaic devices. Fig. 7B is a sectional view of Fig. 7A.

As illustrated in the planar view of Fig. 7A, the photovoltaic device which is the inspection-object 200 is configured in such a manner that plural rectangular photovoltaic cells 28 are connected in series by lead wires 29 to form a string 25, and plural columns of strings 25 are connected by lead wires 29.

The photovoltaic device as the inspection-object 200 may be formed with a single photovoltaic cell 28 only, or may be formed with the string 25 in which the plural photovoltaic cells 28 are straightly connected, or may be a photovoltaic device panel 30 in which the plural columns of strings 25 are disposed in parallel and the photovoltaic cells 28 are disposed in matrix.

As illustrated in Fig. 7B, the sectional structure of the inspection-object is formed by disposing the plural columns of strings 25 sandwiched by filling members 23 and 24 between a back side member 22 disposed on an upper side thereof and a transparent cover glass 21 disposed at a lower side thereof.

The back side member 22 is formed of, for example, polyethylene resin or a fluororesin or the like. The filling members 23 and 24 are formed of, for example, EVA resin (polyethylene vinyl acetate resin) or the like. As described above, the string is formed by connecting the photovoltaic cells 28 with lead wires 29 between electrodes 26 and 27.

Such a photovoltaic device panel is obtained by stacking the aforementioned constituent members and laminating. The laminating process is performed by pressing with force under heating in vacuum to cross-link the EVA resin with a laminator or the like.

Moreover, a kind of photovoltaic devices, which is generally called as a thin film-type, may be employed as the inspection-object 200.

For example, a typical structure of this kind of thin film-type photovoltaic devices is obtained in the following way of: depositing a power generating element comprised of a transparent electrode, a semiconductor and a rear back electrode in advance via vacuum evaporation on the transparent cover glass disposed at the lower side; disposing the transparent cover glass at the lower side; covering the photovoltaic devices elements deposited on the glass with the filling members; covering the filling members with the back side member; and laminating the stacked members with a laminator.

Except that crystalline cells is replaced with deposition-typed power generating elements, the basic sealing structure of this kind of thin film-typed photovoltaic devices as the inspection-object 200 is the same as the case of the crystalline cells in the aforementioned description.

### < 2 > Entire configuration of the inspection apparatus

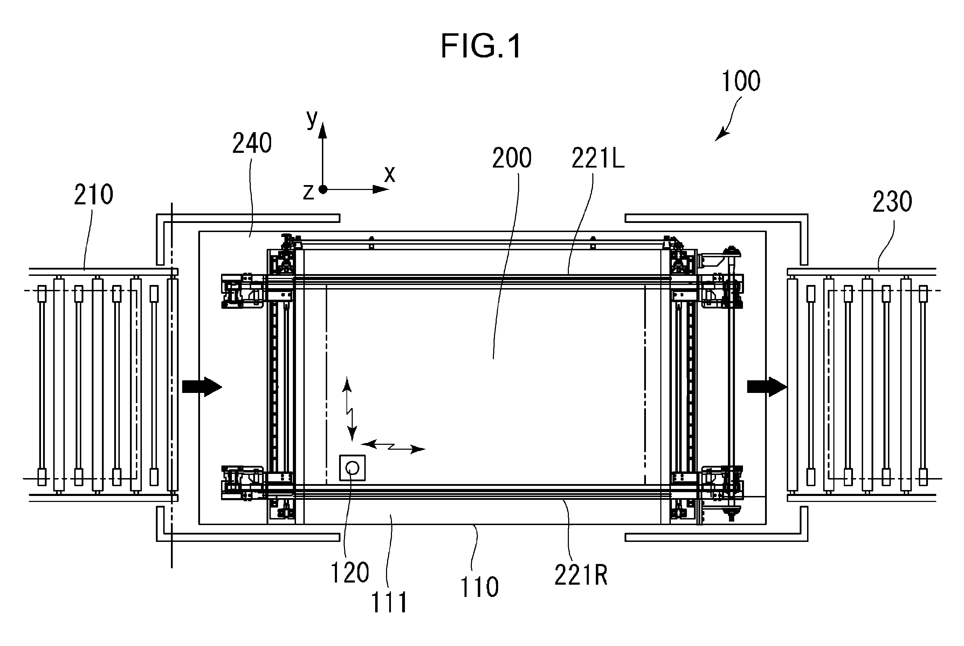

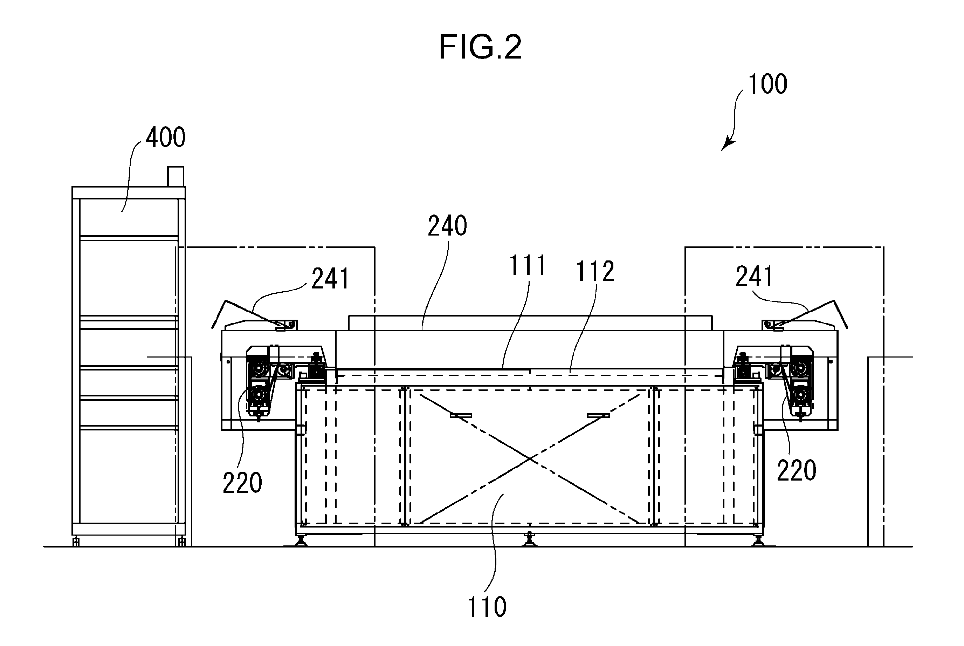

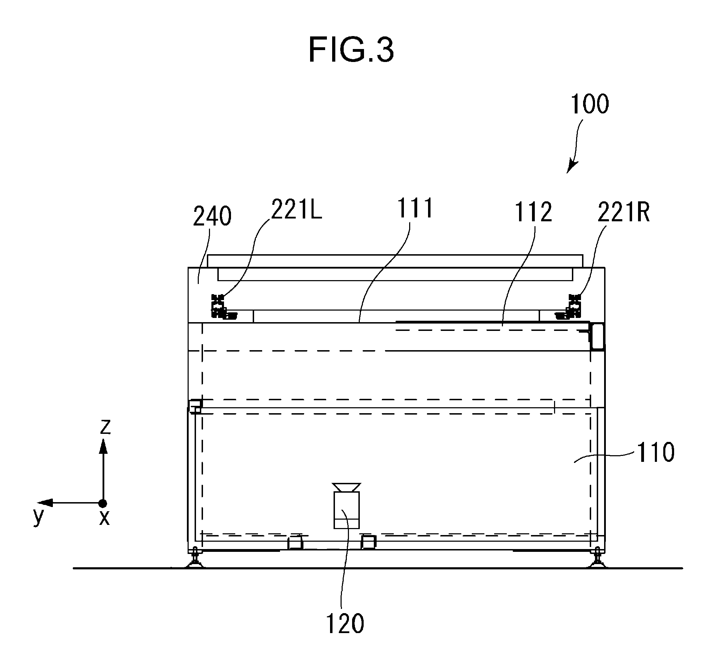

Fig. 1 is a planar view illustrating a structure of an inspection apparatus according to the present invention, Fig. 2 is a front view thereof, and Fig. 3 is a left-side view thereof. The inspection apparatus 100 for the photovoltaic devices according to the present invention, as illustrated in the drawings, has a cubic box-shaped darkroom 110. The opening 112 is disposed at a flat upper surface 111 thereof. The opening 112 may be provided with a transparent plate for preventing dust or foreign matters from entering the darkroom and for keeping inspection-objects from falling into the darkroom. The transparent plate to be used may be one made of a synthetic resin such as an acrylic resin or of glass. A camera 120 is provided in the darkroom for inspection and measurement of inspection-objects 200, i.e., photovoltaic devices (photovoltaic cells, strings, photovoltaic device panels). The camera may be used by fixing in the darkroom. Alternatively, the camera 120 may be used by moving when used, and in this case, a moving mechanism may be provided. The camera moving mechanism is described later.

The darkroom 110 is formed of a shading material to prevent light rays from entering the darkroom 110, except the opening (the transparent plate) 112 of the upper surface 111 thereof. Notwithstanding, it is also possible to make the entire upper surface 111 of the opening (the transparent plate) if the photovoltaic devices as the inspection-object 200 is disposed on the upper surface 111 and then the entire upper surface 111 including the inspection-object 200 is covered with the shading means. Except the upper surface, the four side surfaces and the bottom surface are formed of shading material.

In case where no transparent plate is provided in the opening 112 in the upper surface 111 of the darkroom, means for supporting photovoltaic devices, i.e., inspection-objects, is provided. The supporting means may be, as described later, a transport guide mechanism for the inspection-objects. Alternatively, the supporting means may be members for supporting two ends or four corners of a photovoltaic as an inspection-object.

### < 3 > Transporting and positioning of inspection-object

A transport apparatus 220 is provided on the top of the upper surface 111 so as to transport an inspection-object 200 into the present inspection apparatus and to load and unload the inspection-object from a pre-process and to a post-process. The transport apparatus may use a chain conveyor or a belt conveyor that is actuated by an electric motor. The transport apparatus 220 is provided with transport guide portions 221R/L with a function of transporting and guiding inspection-objects 200. The distance in-between the transportation guide members 221R and 221L is configured so as to adjust in accordance with the size of the inspection-objection 200.

When a photovoltaic device, i.e., an inspection-object, is transported from the pre-process of the inspection apparatus of the present invention, a transporting-in conveyor 210 of the present inspection apparatus transports the photovoltaic devices in the direction indicated by the black painted arrow in Fig. 1 and transports onto the transport guide portions 221R/L of the present inspection apparatus. The inspection-object 200 is moved and transported by the conveyor apparatuses 220 of the transport guide portions. Thus, the cover glass 21 at the lower surface of the inspection-object 200 does not touch the transparent plate 112 at the upper surface of the inspection apparatus 100 during the transportation or measurement of the inspection-object 200. The inspection-object 200 is transported within the present inspection apparatus to be positioned at a measurement position as follows.

The transport guide portions 221R/L have at their side surfaces positioning metal members that are capable of being protruded and withdrawn by, e.g., an actuator. The inspection-object 200 transported is positioned in the direction in which the inspection-objects are transported, by the positioning metal members protruded. The positioning metal members may be so configured as to ascend or descend from upper portions of the transport guide members 221R/L or to rotatingly descend from the guide members, instead of being protruded and withdrawn from the side surfaces of the guide members.

Upon completion of positioning of the inspection-object, the conveyor apparatus stops to start the inspection. The inspection method is described later. At the completion of inspection, the conveyor apparatus 220 is actuated and the inspection-object 200 is transferred to a carrying-out conveyor 230 (in the direction indicated by the black painted arrow in Fig. 1) to be transported to the subsequent process.

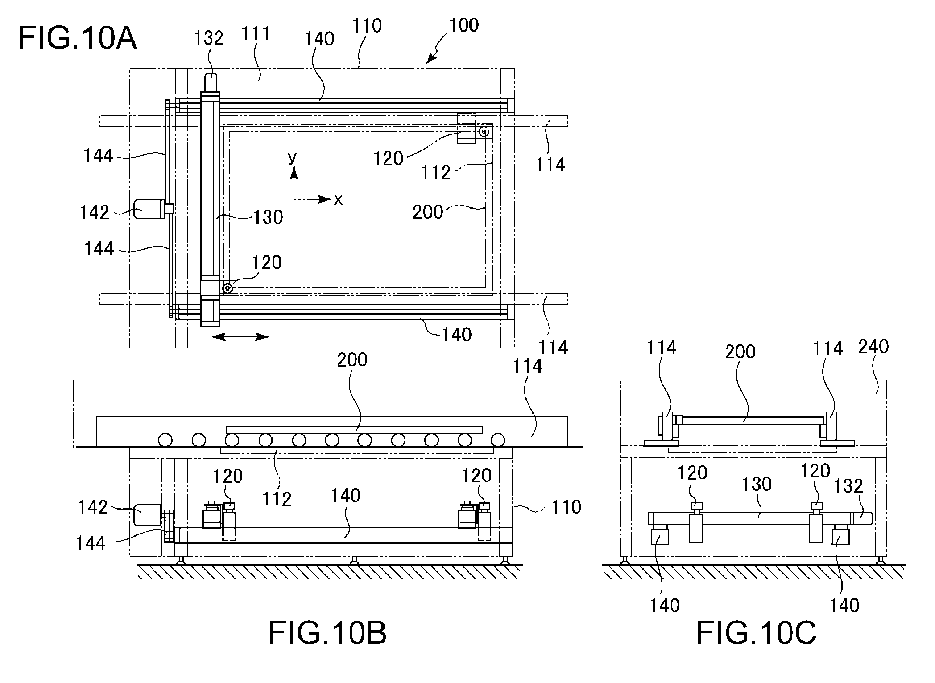

The means for transporting the photovoltaic devices, i.e., the inspection-objects, may have the configuration as illustrated in Fig. 10. Guide members 114 at the upper surface of the darkroom have a narrow rail-like shape with a rectangular cross section. The guide members 114 are provided in a pair on the upper surface of the inspection apparatus 100 of the present invention, along the transporting direction of the inspection-objects 200. Plural rollers are disposed on the respective inner side surfaces of the guide members 114 such that the inspection-objects 200 are transported on the rollers. The transporting means may be operated manually or may be configured such that the rollers are driven by, e.g., an electric motor.

### < 4 > Photographing camera

The EL light emitted from the inspection-object 200 is a weak light ray of wavelength between 1,000 nm and 1,300 nm, is emitted in the darkroom 110 and the weak light ray is photographed by using the photographing camera 120. Therefore, it is necessary to use a CCD camera which has high sensitivity to weak light ray as the photographing camera 120.

Although a camera moving mechanism is not illustrated in Figs. 1, 2, and 3 of the embodiment, the camera 120 can move to arbitrary position within the x-y plane and photograph the entire surface of the inspection-object 200 by providing the moving mechanism for camera. The moving mechanism for the camera 120 need not necessarily be provided, and the camera 120 may be used in a fixed state.

### < 5 > Moving Mechanism for the Camera in the Darkroom

Fig. 10 illustrates the configuration of a camera moving mechanism. The camera 120 and a y-axis guide portion 130 for allowing the camera 120 to move in the y-axis direction are disposed in the darkroom. The y-axis guide portion 130 has a motor 132 at its end, and the rotation of the motor causes the camera 120 to move back and forth along the y-axis direction.

The y-axis guide portion 130 is supported at its both ends with x-axis guide portions 140. A motor 142 and timing belts 144 provided on both sides thereof allow the y-axis guide portion 130 to move back and forth along the x-axis direction over the x-axis guide portions. In the configuration described above, the x-axis guide portions 140-140, y-axis guide portion 130, motors 132-142, and timing belts 144 constitute a driving mechanism for the camera 120. The x-axis guide portions 140 and the y-axis guide portion 130 may use various linear actuators. Ball screws and motors are employed in the present embodiment.

The rotation of the motors 132 and 142 of the driving mechanism is controlled, such that the camera 120 is moved to arbitrary position within the x-y plane to photograph the entire surface of the inspection-object 200.

The driving system is not limited to the above embodiment using motors and ball screws and various linear actuators may be employed.

### < 6 > A reflector plate within the Darkroom

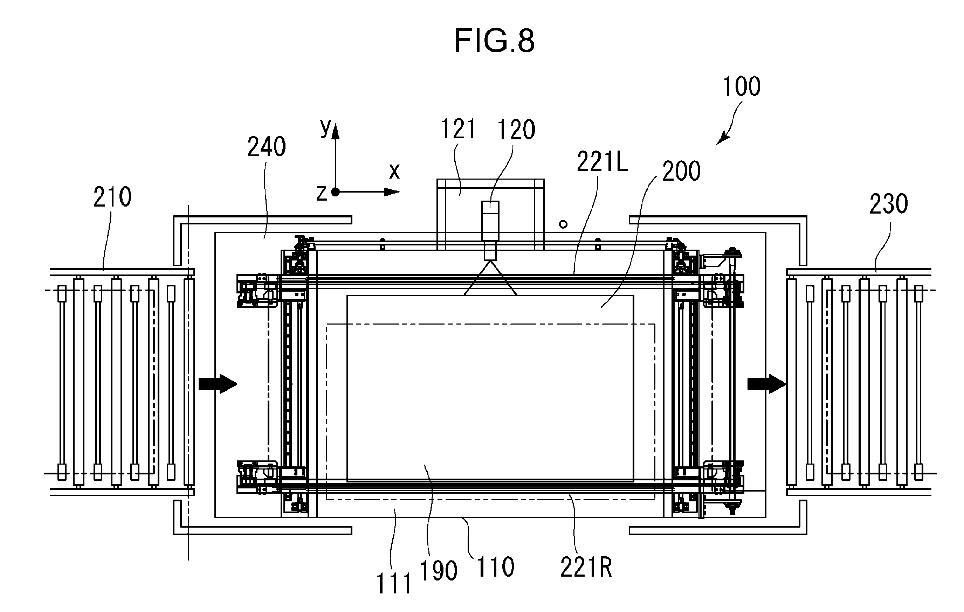

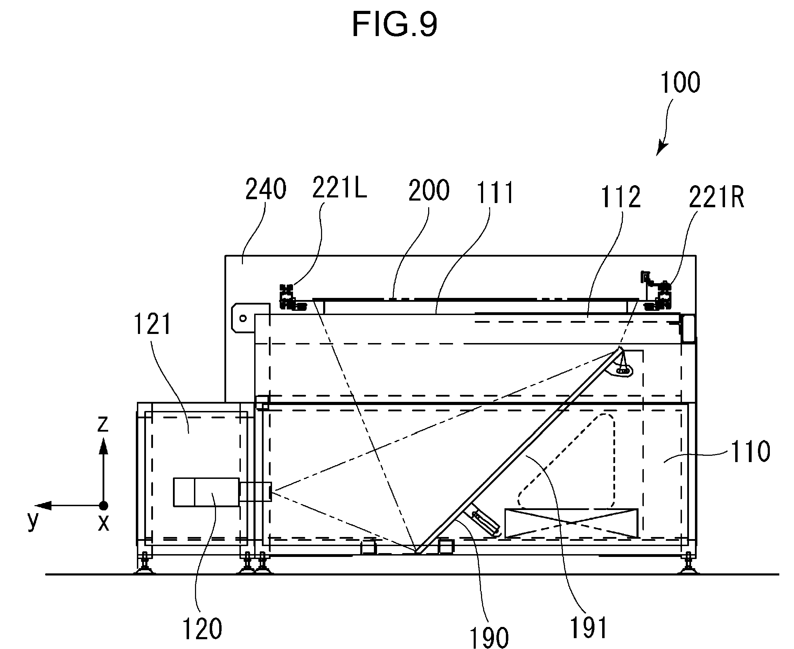

The present inspection apparatus may be configured such that, in the darkroom, a reflector plate 190 is obliquely disposed to the upper surface 111 of the darkroom. Fig. 8 is a planar view illustrating the configuration of the inspection apparatus in which the reflector plate is disposed inside the darkroom, and Fig. 9 is a left side view thereof. A surface-machined metal plate made of aluminum or stainless steel is employed for the reflector plate; however, the material of the reflector plate is not limited to metals and may be any material that is high in reflectivity and is neither transparent nor absorptive of light. The reflector plate is obliquely supported to the opening (transparent plate) 112 by means of a reflector plate support member 191. This enables the camera 120 mounted on a side surface of the darkroom to photograph the image of the inspection-object 200 placed at the opening (on the transparent plate) 112. In Fig. 9 of the embodiment, the angle is approximately 45 degrees, but the angle is not limited thereto.

In Fig. 8 and Fig. 9, a moving mechanism for the camera 120 is not provided. The camera 120 is used by fixing in a camera mounting portion 121. By providing the moving mechanism described in Fig. 10, it is also possible to allow the camera 120 to move to arbitrary position within the z-x plane so as to photograph the entire surface of the inspection-object 200. In this case, the camera mounting portion 121 of Figs. 8 and 9 may be extended in the x direction by the length corresponding to a moving stroke of the camera, so that the camera can move therein.

### < 7 > The other instruments

In addition to the aforementioned means, although not illustrated in the drawings, the inspection apparatus 100 of the present invention is provided with the power source 14 and the image processing apparatus 15 as illustrated in the conventional example of Fig. 15. These are stored in a controlling device 400 in Fig. 2. Furthermore, it is possible to photograph the entire photovoltaic devices in a single piece of photo or to photograph each of the photovoltaic cells 28, by using the personal computer and controlling the moving mechanism.

### < 8 > Usage of the inspection apparatus

A description is given of the usage of the inspection apparatus for the photovoltaic devices of the present invention in the embodiment in which a photovoltaic device is employed as the inspection-object 200.

After the photovoltaic device having been manufactured by a laminator or the like, it is transported in front of the inspection apparatus for the photovoltaic devices of the present invention by the transporting-in conveyor 210. The transported photovoltaic devices is guided between the pair of guide members 221R and 221L, and transported. The photovoltaic device reaches above the darkroom 110. Thereafter, photovoltaic devices is positioned in the direction of transporting by protruding the positioning member 119 disposed at the inner side of the guide members 221L and 221L in a manner that the positioning member 119 is protruded and withdrawn by an actuator or the like.

A shading cover 240 is provided to prevent light from entering the darkroom 110 from, e.g., a gap between the opening (or the transparent plate) 112 at the upper surface 111 of the darkroom and the inspection-object 200.

The photovoltaic devices as the inspection-object 200 reaches a predetermined position on the upper surface 111 of the darkroom 110, then stops on the opening (the transparent plate) 112 of the darkroom 110 with the transparent glass plate disposed at the lower side and is connected with a power source not shown in drawings. Since the inspection-object 200 is smaller than the opening (the transparent plate) 112, light rays enter the darkroom from the vicinity of the inspection-object 200. Therefore, a shading cover or the like which is described hereinafter is disposed to cover the entire upper surface of the darkroom 110 from above the inspection-object 200. Thereafter, a current is applied in a forward direction from the power source to the inspection-object 200. By this electrification, the inspection-object 200 emits EL light, which is photographed by the camera 120.

In the case that the inspection apparatus 100 of the present invention is employed to photograph the entire of the inspection-object 200 and inspect the photovoltaic devices by using the obtained image, it is possible to fix the camera 120 at an approximate center position of the bottom of the darkroom 110 to photograph the inspection-object, without disposing or using the moving mechanism for the camera. In case of using a reflector plate inside the darkroom, the photographing may be performed with the camera fixed at the position of Fig. 8. In this case, the inspection-object 200 may be any one of the photovoltaic cell 28, the string 25 which is formed by connecting plural photovoltaic cells 28 with lead wires, and the photovoltaic device panel 30 in which the plural columns of strings 25 are connected with lead wires and the photovoltaic cells 28 are disposed in matrix.

In the case that the inspection apparatus 100 of the present invention is employed to photograph the respective photovoltaic cells 28 disposed in matrix in the photovoltaic device panel 30 one by one and perform the inspection by using the obtained images, the moving mechanism is needed to be disposed so as to move the camera 120 in the darkroom 110 as illustrated in Fig. 10.

The controlling device 400 drives the moving mechanism for the camera by use of the personal computer not shown in the drawings. The camera 120 photographs the photovoltaic cells 28 disposed in matrix in the photovoltaic device panel 30 one by one, and the obtained image date is transmitted to the image processing apparatus comprised of the personal computer and the like. The image processing apparatus extracts those portions which emit no EL light from the images of the photovoltaic cells, and analyzes them to determine whether the respective photovoltaic cells 28 should be passed or not based on the obtained image data of respective photovoltaic cells. Whether the photovoltaic device panel 30 as a whole should be passed or not is determined on the basis of the results determined whether passed or not for all photovoltaic cells.

Furthermore, respective photovoltaic cells or every few pieces of photovoltaic cells may be photographed by moving the camera and the photovoltaic device panel 30 as a whole may be photographed by fixing the camera without moving.

### < 9 > Shading cover

The entire upper surface 111 of the darkroom 110 is covered by the shading cover. However, in the case of the photovoltaic devices, the back side member 22 made of resin is opaque and has sufficient shading effect. Moreover, the upper surface 111 of the darkroom 110 is comprised of members having shading effect, except the transparent plate 112. Therefore, it is sufficient to cover only the gap portion between the darkroom 110 and the inspection-object 200 with the shading cover. In the case that the inspection-object 200 is disposed in close contact with the transparent plate 112 and is larger than the transparent plate 112 and covers the entire transparent plate 112, the shading means is not necessary.

In the present embodiment, as illustrated in Figs. 1 to 3, the shading cover 240 is configured such that the upper surface 111 of the darkroom, the transportation guide members 221R/L and the inspection-object 200 are covered by a shading cover 240. Doors 241 capable of opening and closing are respectively disposed at the sides of the transporting-in conveyor 210 and the carrying-out conveyor 230. The door 241 may be configured to be opened and closed automatically by using an air cylinder and the like, or manually by operator. The doors are configured as follows. When the inspection-object is transported from the previous process and is right in front of the inspection apparatus of the present invention by moving on the transporting-in conveyor, the door at the inlet side is opened to allow the inspection-object to be transported into the inspection apparatus of the present invention. When the inspection-object is completely transported into the inspection apparatus by the transport apparatus 220, the door is closed. In addition, when the inspection is completed, the door at the outlet side is opened such that the inspection-object 200 is carried out. During inspection, the doors for transporting in and carrying out the inspection-object are held closed. Thus the light rays outside do not enter the space where the inspection-object is disposed.

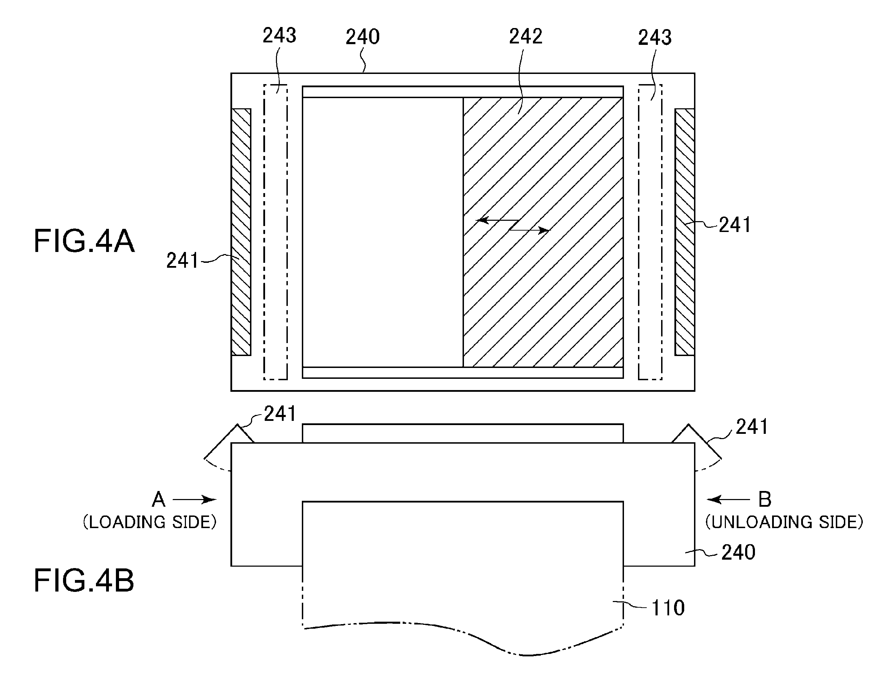

Embodiments of the shading cover of the inspection apparatus of the present invention are described with reference to Figs. 4, 5, and 6.

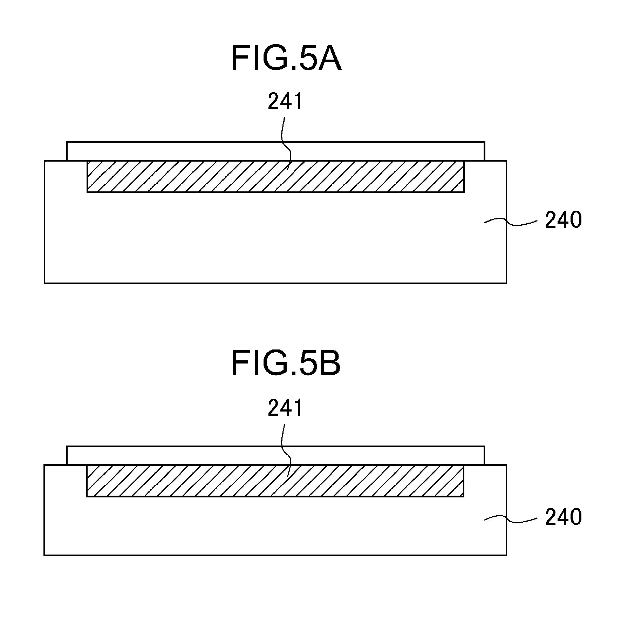

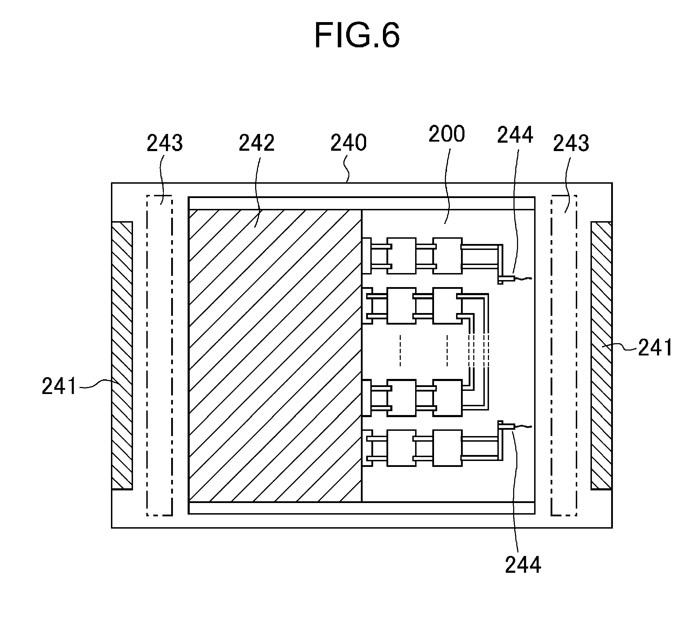

Fig. 4A is a planar view of the shading cover, and Fig. 4B is a front view thereof. Fig. 5A is a side view of the shading cover as seen from the loading side into which the inspection-object is transported (in the A direction). Fig. 5B is a side view of the shading cover as seen from the unloading side of which the inspection-object is carried out (in the B direction). Fig. 6 illustrates a state in which an openable/closable door in the upper surface of the shading cover is opened.

As illustrated in Fig. 4, the shading cover 240 is fixed to the darkroom and covers the entire upper portion of the upper surface of the darkroom 110. The openable/closable doors 241 allow the inspection-object to be transported into and carried out of the inspection apparatus. An openable/closable door 242 is provided in the upper surface of the shading cover, and removable lids 243 are provided for maintenance. These members are all constructed of members with a shading effect. At the juncture of the openable/closable doors and the main body of the shading cover, back sheets such as rubber sheets or the like are preferably attached to portions either on the door side or on the shading cover main body side so as to prevent light-ray from entering the juncture.

The doors 241 may be so configured as to be opened and closed automatically by, e.g., an air cylinder, or may be so configured as to be opened and closed manually by the operator. An inspection-object is transported from the pre-process and is transferred on the transporting-in conveyor to be transported to a position right in front of the present inspection apparatus. The door at the inlet side is opened to allow the inspection-object to be transported and located in the present inspection apparatus, and the door is closed again. Upon completion of the inspection, the door at the outlet side is opened and the inspection-object 200 is carried out. The doors for transporting the inspection-object into and carrying it out of the inspection apparatus is closed during inspection, thus preventing outside light from entering a portion where the inspection-object is placed and the inside of the darkroom.

The openable/closable door 242 is provided in the upper surface of the shading cover. The door 242 may be so configured as to be opened and closed automatically by, e.g., an air cylinder, or may be so configured as to be opened and closed manually by the operator. The inspection-object is transported from the pre-process, the openable/closable door 241 at the inlet side mentioned above is opened, and the inspection-object is transported into the inspection apparatus to reach a predetermined position. Then the door 242 is opened. When the door 242 is opened, the inspection-object 200 appears as illustrated in Fig. 6. The connectors 244 inside the shading cover are connected to the electrodes 26 and 27 of the inspection-object. When the connection is finished, the doors 241 and 242 are closed. In this manner, light-ray dose not enter the darkroom from outside, and the inspection-object is electrified to emit EL light so that inspection is conducted. When the inspection is completed, the door 242 is opened again, and the connectors 244 are disconnected from the electrodes. After that, the door 241 at the outlet side is opened again, and the inspection-object is carried out from the present inspection apparatus. The operations of connection to the electrode and disconnection of the connectors from the electrodes may be performed manually by the operator or may be automated, e.g., by using a robot.

Preferably, opening for maintenance is appropriately provided to the shading cover of the present inspection apparatus. As one example, in Fig. 4, such openings are provided in the upper surface of the shading cover at two positions as indicated with the long dashed double-short dashed lines and are covered with the lids 243. The present invention is not limited thereto, and the openings may be appropriately provided in the upper surface or a side surface of the shading cover, provided that the openings are covered with lids.

In the description of the present embodiment, the shading cover 240 is configured to cover the entire upper surface of the darkroom and to be fixed to the darkroom. Meanwhile, the shading cover 240 may be movably configured to ascend and descend by an actuator.

The resinous back side members 22 of the photovoltaic devices are opaque and have a sufficient shading effect. The upper surface 111 of the darkroom 110 except the opening (transparent plate) 112 is also formed of a member with a shading effect. Thus, such a configuration may be employed that the gap portion between the opening (transparent plate) 112 of the darkroom 110 and the inspection-object 200 is covered with a shading member.

In the inspection apparatus 100 for the photovoltaic devices according to the present invention, the photovoltaic devices as the inspection-object 200 may be disposed outside the darkroom, and doors for transporting the inspection-object 200 into and carrying it out of the darkroom need not be provided. Further, the power source and wires for applying current to photovoltaic devices may be disposed outside the darkroom 110 and are not required at all inside the darkroom. Hence, the structure of the darkroom 110 is simplified.

Since an openable/closable door is provided in the upper surface of the shading cover of the inspection apparatus of the present invention, connection of connectors to electrodes of a photovoltaic devices in applying current in a forward direction to the photovoltaic cells is facilitated. Moreover, since openable/closable doors are provided in side surfaces of the shading cover of the present inspection apparatus, photovoltaic devices as inspection-objects can be transported in and carried out from the apparatus easily.

The shading cover of the inspection apparatus of the present invention facilitates automation of operations of transporting inspection-objects into and carrying them out of the inspection apparatus and of connecting connectors to electrodes of photovoltaic devices. The inspection apparatus of the present invention is therefore suitable for automation of production lines for photovoltaic devices.

Particularly, the reflector plate 190 is disposed obliquely to the inspection-object 200. Therefore, installing the camera sideways inside the darkroom leads to reduction in height of the darkroom 110, and further downsizing of the apparatus is achieved. This eliminates the need of incidental works, such as digging out the ground of the portion at which the apparatus is installed, for unifying the pass-line of the production line.

The inspection apparatus 100 for photovoltaic devices according to the present invention is installed for use in a production line of, e.g., photovoltaic devices. When the inspection apparatus is in operation, a photovoltaic device is disposed on the upper surface 111 of the darkroom 110 with its light receiving surfaces facing down. In normal processes such as a lamination process of photovoltaic devices, since the light receiving surfaces of photovoltaic devices are faced down during transportation and inversion is not necessary for loading in the inspection apparatus 100, production processes can be simplified.

A description is given of embodiments of the transport apparatus for the inspection apparatus according to the present invention with reference to the accompanying drawings.

### <10> Inspection-object (a stack of constituent members of a photovoltaic devices)

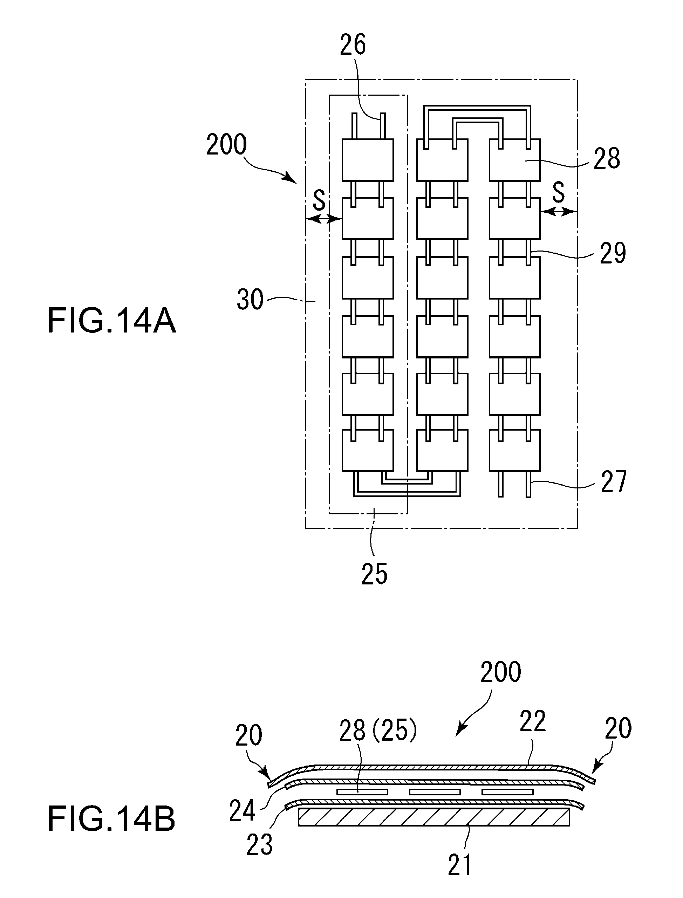

First, the description will be given of a separate example of an inspection-object 200 which is inspected by an inspection apparatus of an embodiment according to the present invention. Fig. 14A and Fig. 14B illustrate a photovoltaic devices inspected by the inspection apparatus of the present invention. Fig. 14A is a planar view showing photovoltaic cells inside the photovoltaic devices. Fig. 14B is a sectional view of Fig. 14A as seen in a direction in which the inspection-object is transported.

As illustrated in the planar view of Fig. 7A, the photovoltaic devices which is the inspection-object 200 is configured in such a manner that plural rectangular photovoltaic cells 28 are connected in series by lead wires 29 to form a string 25, and plural columns of strings 25 are connected by lead wires 29.

The photovoltaic devices as the inspection-object 200 may be formed with a single photovoltaic cell 28 only, or may be formed with the string 25 in which the plural photovoltaic cells 28 are straightly connected, or may be a photovoltaic device panel 30 in which the plural columns of strings 25 are disposed in parallel and the photovoltaic cells 28 are disposed in matrix.

As illustrated in Fig. 14B, the sectional structure of the inspection-object is formed by disposing the plural columns of strings 25 sandwiched by filling members 23 and 24 between a back side member 22 disposed on an upper side thereof and a transparent substrate 21 disposed at a lower side thereof. The present inspection apparatus performs measurement to inspect defects in the photovoltaic cells with the pre-laminated constituent members of photovoltaic devices being stacked. As illustrated in Fig. 14(b), the back side member covering the transparent substrate, photovoltaic cells, and filling members sticks out widely thereof, as they are in a pre-laminated state. In addition to this example, inspection may be performed by the present inspection apparatus with the transparent substrate 21, filling member 23, and photovoltaic cells 28 (25 or 30) stacked, and after that, the back side member 22 and filling member 24 may be stacked thereon.

For example, PET or a fluororesin may be used for the back side member 22. Thus, the portions sticking out of the transparent substrate droop. For example, an EVA resin (ethylene vinyl acetate resin) may be used for the filling members 23 and 24. The strings 25 have a structure in which photovoltaic cells 28 are connected with lead wires 29 between electrodes 26 and 27, as aforementioned.

Regarding the inspection-object 200, a so-called thin film type photovoltaic device described in the section <1> may be an inspection-object.

### <11> Embodiment 1 of the transport apparatus of the present invention

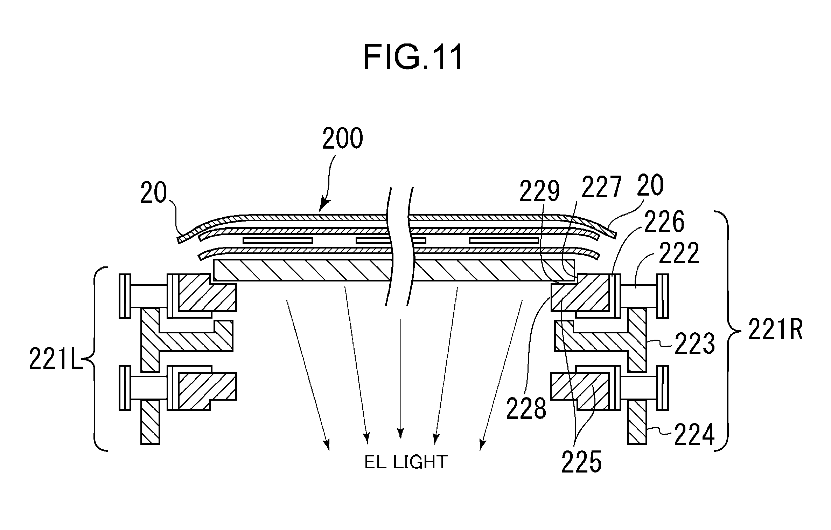

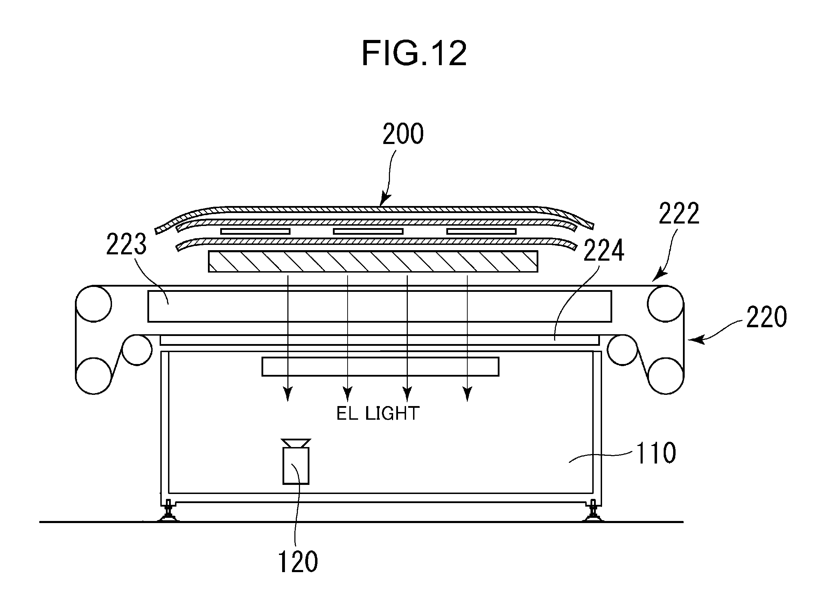

A first embodiment of the transport apparatus for the inspection apparatus of the aforementioned <10> is described with reference to Figs. 11 and 12. Fig. 11 is a front view as seen in the direction of transportation, and Fig. 12 is a side view thereof. The transport portions 221R/L each include a chain 222, an upper chain guide 223, a lower chain guide 224, transport guides 225, and attachments 226 for the transport guides. A plurality of transport guides are provided to the chains by using the attachments and are connected endlessly by means of the chains. The chains are supported with the upper chain guide and the lower chain guide disposed in the direction of transportation. The transport portions are provided in a pair (in two rows) symmetrically with respect to the direction of transportation. As illustrated in Fig. 11, an inspection-object 200 is disposed and transported on the transport guides 225.

As has been already described, since the transported inspection-object is in the pre-laminated state, the transparent substrate, photovoltaic cells, filling members, and back side member are in a stacked state. Thus, the back side member sticks out widely from the transparent substrate. The sticking-out portions of the back side member droop downward. In order to prevent the drooping portions 20 from touching any of the members of the transport apparatus, a device as described below is added to the transport guides 225. The transport guides 225 as seen in the direction of transportation have a substantially L-shape. Wall portions 227 thereof guide ends of the transparent substrate 21. The height dimension of the wall portions is possibly lower than the thickness dimension of the transparent substrate. In case where it is unavoidable for the back side member to touch a member of the transport apparatus even with the possibly lowest dimension of the wall portions, the dimension of thickness portions 228 of the transport guides is adjusted so as to prevent the drooping portions of the back side member from touching the member of the transport apparatus.

Transparent substrate supporting portions 229 of the transport guides 225 are decided according to the distance S (see Fig. 14A) from the end of the transparent substrate to the nearest photovoltaic cell.

The transport portions 221R/L are so configured as to be positionally changeable according to the width dimensions of the transparent substrates of photovoltaic devices. The transport portions 221R/L may be positionally changed independently. Alternatively, the transport portions 221R/L may be equally brought close to or away from each other simultaneously by means of a screw mechanism.

### <12> Embodiment 2 of the transport apparatus of the present invention

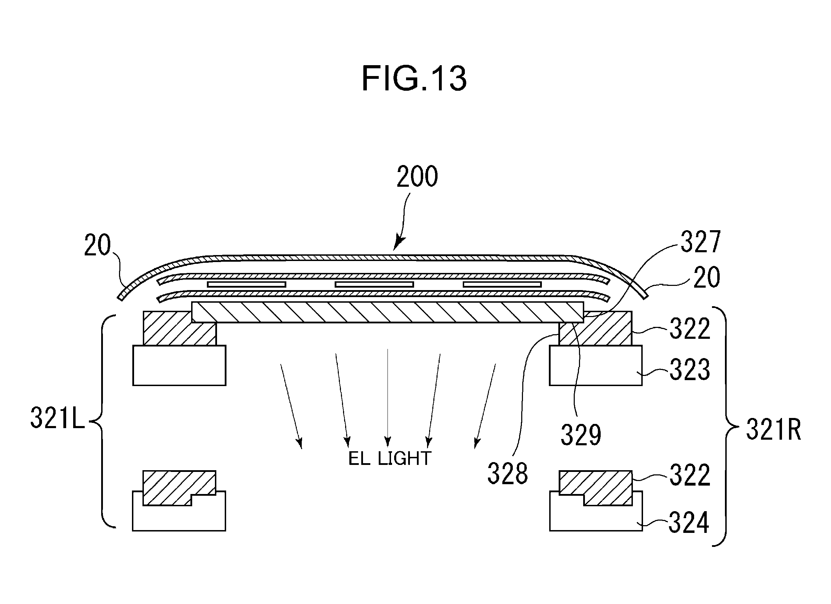

A second embodiment of the photovoltaic devices inspection apparatus transport apparatus of the aforementioned <10> employs, as illustrated in Fig. 13, transport guides in the form of endless belt-like members 322 having a similar cross section of the transport guides 225, instead of employing the plurality of transport guides provided to the chains as illustrated in Figs. 11 and 12.

Transport portions 321R/L each include the endless belt-like member 322, an upper belt support 323, and a lower belt support 324. The transport portions are provided in a pair (in two rows) symmetrically with respect to the direction of transportation. As illustrated in Fig. 13, an inspection-object 200 is disposed and transported on the belt-like members 322.

Since the inspection-object transported in the similar manner as in Embodiment 1 is in a pre-laminated state, the transparent substrate, photovoltaic cells, filling members, and back side member are in a stacked state. Thus, the back side member sticks out widely from the transparent substrate. The sticking-out portions of the back side member droop downward. In order to prevent the drooping portions 20 from touching any of the members of the transport apparatus, a device as described below is added to the belt-like members. The belt-like members 322 as seen in the direction of transportation have a substantially L-shape. Wall portions 327 thereof guide ends of the transparent substrates 21. The height dimension of the wall portions is possibly lower than the thickness dimension of the transparent substrate. In case where it is unavoidable for the back side member to touch a member of the transport apparatus even with the possibly lowest dimension of the wall portions, the dimension of thickness portions 328 of the belt-like members is adjusted so as to prevent the drooping portions of the back side member from touching the member of the transport apparatus.

Transparent substrate supporting portions 329 of the belt-like members are decided according to the distance S (see Fig. 14A) from the end of the transparent substrate to the nearest photovoltaic cell.

The transport portions 321R/L are so configured as to be positionally changed according to the width dimensions of the transparent substrates of photovoltaic devices. The transport portions 321R/L may be positionally changed independently. Alternatively, the transport portions 321R/L may be equally brought close to or away from each other simultaneously by means of a screw mechanism.

### <13> A method of using the present inspection apparatus and the transport apparatus of the present invention

A method of using the transport apparatus for the inspection apparatus is described, taking an example where stacks of constituent members of photovoltaic devices are the inspection-objects 200.

The photovoltaic device as an inspection-object 200 is constituted by a transparent substrate, photovoltaic cells, filling members and a back side member. These members are stacked in a pre-laminated state. The inspection-object is transported to a position before the inspection apparatus for photovoltaic devices by the transporting-in conveyor 210. The inspection-object transported thereto reaches a position above the darkroom 110 by transporting and guiding between the pair of transport guides 225 or between the pair of belt-like members 322. After that, the positioning metal members, which are provided on side surfaces of the transport apparatus so as to be protruded and withdrawn by, e.g., an actuator, are protruded, such that the photovoltaic device is positioned in place along the direction of transportation.

Since devices are added to the transport guides and the belt-like members as described above, the drooping portions 20 of the back side member of the inspection-object do not touch a constituent member of the transport apparatus during transportation. Thus, the constituent members of the inspection-object are transported to the present inspection apparatus without positional deviation among each other.

The method of using the present inspection apparatus 100 and the transport apparatus of the present invention is as described above. Hence, a transparent substrate, photovoltaic cells, filling members, and a back side member, which are constituent members of photovoltaic devices, i.e., inspection-objects, are stacked in a pre-laminated state. The constituent members of photovoltaic devices are transported to the inspection apparatus without positional deviation among each other by employing the transport apparatus of the present invention to the present inspection apparatus. Accordingly, defect inspection can be performed normally through the above inspection method.

## Claims

1. An inspection apparatus for photovoltaic devices, comprising:
a darkroom having an opening in a top surface thereof;
support means provided on the top surface of the darkroom on which a photovoltaic device as an inspection-object can be disposed;
a camera disposed within the darkroom; and
a shading cover that prevents light from entering the darkroom from the opening in the top surface of the darkroom and from a gap in a boundary between the opening in the top surface of the darkroom and a photovoltaic device disposed on the support means.

2. The inspection apparatus for photovoltaic devices according to claim 1, further comprising an openable/closable door provided on a side surface of the shading cover for transporting a photovoltaic device as an inspection-object into the inspection apparatus for photovoltaic devices, and for carrying out the photovoltaic device therefrom.

3. The inspection apparatus for photovoltaic devices according to either claim 1 or 2, further comprising an openable/closable door provided in a top surface of the shading cover.

4. The inspection apparatus for photovoltaic devices according to any one of claims 1 to 3, further comprising a drive mechanism for moving the camera.

5. The inspection apparatus for photovoltaic devices according to any one of claims 1 to 4, further comprising a reflector plate disposed inside the darkroom obliquely to the top surface of the darkroom.

6. An inspection apparatus for photovoltaic devices **characterized by**:
a darkroom having a flat top surface;
a transparent plate provided at the top surface of the darkroom on which a photovoltaic device as an inspection-object can be disposed;
a camera disposed within the darkroom; and
a shading cover that prevents light from entering the darkroom from the transparent plate and from a gap in a boundary between the transparent plate and a photovoltaic device disposed on the transparent plate.

7. The inspection apparatus for the photovoltaic devices according to claim 6, further **characterized by** an openable/closable door provided on a side surface of the shading cover for transporting a photovoltaic device as an inspection-object into the inspection apparatus for photovoltaic devices, and for carrying out the photovoltaic device therefrom.

8. The inspection apparatus for photovoltaic devices according to either claim 6 or 7, further **characterized by** an openable/closable door provided in a top surface of the shading cover.

9. The inspection apparatus for photovoltaic devices according to any one of claims 6 to 8, further **characterized by** a drive mechanism for moving the camera.

10. The inspection apparatus for photovoltaic devices according to any one of claims 6 to 9, further **characterized by** a reflector plate disposed inside the darkroom obliquely to the top surface of the darkroom.

11. In an inspection apparatus for photovoltaic devices, a transport apparatus for the inspection apparatus that transports stacked constituent members of a photovoltaic device in a pre-laminated state to the inspection apparatus, wherein the inspection apparatus includes a darkroom having a flat top surface, a transparent plate provided at the top surface of the darkroom on which the photovoltaic device can be disposed as an inspection-object, and a camera which photographs an image of the inspection-object,
the transport apparatus comprising a pair of parallel rows of transport guide portions disposed symmetrically with respect to a transport direction in which a photovoltaic device is to be transported, each transport guide portion endlessly connecting a plurality of guide members having wall portions lower than a thickness of a transparent substrate that is a constituent member of the photovoltaic device to be transported, to guide the transparent substrate of the photovoltaic device with the wall portions during transport.

12. The transport apparatus for the inspection apparatus according to claim 11, comprising a pair of parallel rows of transport guide portions disposed symmetrically with respect to a direction in which the photovoltaic device is to be transported, each transport guide portions including an endless belt-like member having wall portions lower than a thickness of a transparent substrate that is a constituent member of the photovoltaic device to be transported, to guide the transparent substrate of the photovoltaic device with the wall portions during transport.

13. The transport apparatus for the inspection apparatus according to either claim 11 or 12, **characterized in that** positions of the wall portions of the transport guide portions of the transport apparatus can be changed according to a width of the transparent substrate that is a constituent member of a photovoltaic device to be transported.
